(19) Europäisches Patentamt / European Patent Office / Office européen des brevets

(11) **EP 2 017 884 A2**

(12) **EUROPEAN PATENT APPLICATION**

(43) Date of publication:
**21.01.2009 Bulletin 2009/04**

(51) Int Cl.:
**H01L 21/74** *(2006.01)*      **H01L 33/00** *(2006.01)*

(21) Application number: **08252464.6**

(22) Date of filing: **18.07.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **20.07.2007 AU 2007903940**

(71) Applicant: **Gallium Enterprises Pty Ltd**
**Silverwater, NSW 2128 (AU)**

(72) Inventors:
• **Butcher, Kenneth Scott Alexander**
**South Miranda, NSW 2228 (AT)**
• **Wintrebert EP Fouquet, Marie-Pierre Francoise**
**Glebe, NSW 2037 (AT)**
• **Fernandes, Alanna Julia**
**Kings Langley, NSW 2147 (AT)**

(74) Representative: **Bates, Philip Ian**
**Reddie & Grose**
**16 Theobalds Road**
**London**
**WC1X 8PL (GB)**

(54) **Buried contact devices for nitride-based films and manufacture thereof**

(57)      A semiconductor device comprising: a substrate; a first contact; a first layer of doped semiconductor material deposited on the substrate; a semiconductor junction region deposited on the first layer; a second layer of doped semiconductor material deposited on the junction region, the second layer having opposite semiconductor doping polarity to that of the first layer; and a second contact; wherein the second contact is in electrical communication with the second layer and the first contact is embedded within the semiconductor device between the substrate and the junction region and is in electrical communication with the first layer;; and processes for manufacture of an embedded contact semiconductor device.

FIGURE 2

EP 2 017 884 A2

**Description**

**TECHNICAL FIELD**

The invention relates to semiconductor devices and in particular to semiconductor devices formed from GaN-based semiconductor material films.

The invention has been developed primarily for use as a GaN and/or InGaN and/or AlGaN based semiconductor device containing embedded conductive (eg. metal) contacts and will be described hereinafter with reference to this application. However, it will be appreciated that the invention is not limited to this particular field of use.

**BACKGROUND OF THE INVENTION**

Any discussion of the prior art throughout the specification should in no way be considered as an admission that such prior art is widely known or forms part of the common general knowledge in the field.

Gallium nitride is a material widely used in the construction of blue, violet and white light emitting diodes, blue laser diodes, ultraviolet detectors and high power microwave transistor devices.

Because of the actual and potential uses of gallium nitride in the manufacture of low energy consumption devices suitable for use in a wide range of applications, there is great interest in gallium nitride films.

Remote plasma enhanced chemical vapour deposition (RPECVD, which may be used interchangeably with RPCVD) is another growth method that can be used for growing films of Group (III) metal nitrides. Where the film to be grown is gallium nitride, the RPECVD technique enables the use of a growth temperature of about 500°C to about 800°C, or about 500°C to about 700°C, which is considerably lower than the growth temperature of the MOCVD process and enables the reduction of equipment costs. Another advantage of the RPECVD process is that temperature sensitive substrate materials more closely lattice matched to GaN, such as zinc oxide, can be used.

While RPECVD, by virtue of the remoteness of the plasma source from the substrate, is widely believed to be a technique that avoids film damage from species generated in the plasma, the inventors have found that films grown by this method can suffer severe damage even from relatively low energy species. To overcome the problems of this process particular to GaN films and alloys thereof, the Applicant's have disclosed methods and apparatus for growth of GaN films by the REPCVD process a further reduction of the energy of the active neutral nitrogen species that reach the substrate in Patent Co-operation Treaty publication number WO/2006/034540 entitled *Method and apparatus for growing a group (III) metal nitride film and a group (III) metal nitride film*, the contents of which are wholly incorporated herein by cross-reference. The process described in WO/2006/034540 also provide for growth of a film of gallium nitride, wherein the oxygen contamination of the gallium nitride film is minimised and new heater designs capable of withstanding the harsh operating conditions encountered in an RPECVD growth system used for growing metal nitrides.

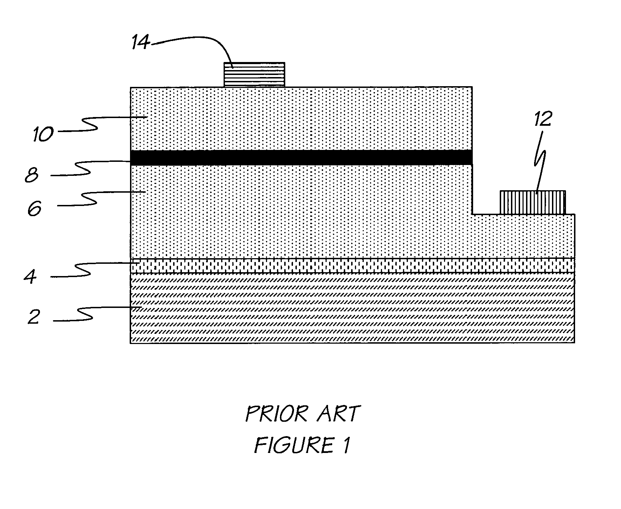

Whilst the techniques for growing metal nitride films has been achieved, there has been considerable difficulty in the growth of metal nitride semiconductor devices with structures other than that of a mesa structure. Other methods of growing metal-nitride devices are used such as deposition on conductive SiC and laser lift of GaN, however these methods are also problematic: SiC is very expensive and device yields using laser lift-off methods are very low due to damage to GaN in the device caused by laser heating. Chemical lift-off techniques are also known for example by growing the device on a sacrificial buffer layer and chemical etching to remove this buffer layer after growth (see for example the use of chromium nitride (CrN) as such a buffer layer in Ha et al, IEEE Photonic Technology Letters 2008, 20(3) p.175-177). Chemical etch techniques, however, are also problematic due to the extra device processing this introduces, for example the need to provide etch vias in the film which is an area that is not a mature technology and is still being investigated for GaN devices. Direct growth on a metal nitride layer removes the need for further chemical etching processing. However, the current methods for manufacturing semiconductor devices having embedded (or interchangeably, buried) contacts for making electrical contact to the device structure are not transferable to metal nitride films. Therefore, the metal nitride devices have been limited to mesa-type structures similar to that of **Figure 1**, wherein there is included a substrate **2**, a buffer layer **4**, a first layer of either n- or p-type doped semiconductor material **6**, a junction region **8**, a second layer **10** of semiconductor material oppositely doped to the first layer (i.e. p- or n-doped), and contacts **12** and **14** respectively in contact to semiconductor layers **10** and **6**, where the contacts **12** and **14** are each exposed to enable making electrical contact to the semiconductor device. The drawback to this arrangement is that the effective distance between the contacts **12** and **14** may be in the order of a few tens of micrometers up to as much as many hundreds of micrometers. This large distance between contacts **12** and **14** consequently results in a large series resistance between the contacts that must be overcome prior to operation of the device and thus has detrimental consequences in the form of device efficiency and unwanted heat generation in the device structure (refer to Chakraborty et al. IEEE Transactions of Electron. Devices 2007, 54(5) for further discussion of series resistance in GaN semiconductor devices). With embedded contacts in the device structure, the effective separation between the contacts may be significantly reduced with clear benefits regarding the device series resistance and operational efficiency.

The difficulty of manufacturing embedded contact structures arises in the case of metal nitride semiconductor devices due to the inability of metal contacts to survive the aggressive chemical environments employed during the MOCVD or HVPE (hydride vapour phase epitaxy) growth of gallium nitride. In particular, the presence of ammonia and/or halogen based gases at the relatively high temperatures typically employed, ensures that most metal contacts would be damaged prior to the deposition of a GaN layer. A further complication is the diffusion of metal from the contact layer into the GaN, a problem which is much reduced by film growth at lower temperatures.

Accordingly, there is a need for metal nitride semiconductor devices, in particular those formed from GaN materials, having embedded/buried contacts, and processes for the manufacture of such devices.

The term "comprising" as used herein means "including principally, but not necessarily solely". Furthermore, variations of the word "comprising", such as "comprise" and "comprises", have correspondingly varied meanings.

## SUMMARY OF THE INVENTION

It is an object of the present invention to overcome or ameliorate at least one of the disadvantages of the prior art, or to provide a useful alternative.

Throughout the specification, the terms embedded or embed can be used interchangeably with the terms buried and bury.

According to a first aspect there is provided a semiconductor device comprising:

a substrate;

a first contact;

a first layer of doped semiconductor material deposited on the substrate;

a semiconductor junction region deposited on the first layer;

a second layer of doped semiconductor material deposited on the junction region, the second layer having opposite semiconductor doping polarity to that of the first layer; and

a second contact;

wherein the second contact is in electrical communication with the second layer and the first contact is embedded within the semiconductor device between the substrate and the junction region and is in electrical communication with the first layer. The first contact may be in direct or indirect electrical communication with the first layer. The first contact may be in electrical communication with the first layer via a conducting buffer layer.

In a particular arrangement there is provided a semiconductor device comprising:

a substrate;

a first buried contact;

a first layer of doped semiconductor material deposited on the substrate;

a semiconductor junction region deposited on or adjacent to the first layer;

a second layer of doped semiconductor material deposited on the junction region, the second layer having opposite semiconductor doping polarity to that of the first layer; and

a second contact;

wherein the second contact is in electrical communication with the second layer and the first contact is buried within the semiconductor device between the substrate and the junction region and is in electrical communication with the first layer. The first contact may be in direct or indirect electrical communication with the first layer. The first contact may be in electrical communication with the first layer via a conducting buffer layer.

According to a second aspect there is provided a semiconductor device formed from semiconductor nitride materials comprising:

a substrate;

at least one first contact on the substrate;

a first semiconductor nitride layer wherein the first contact is embedded in the first layer and in electrical communication with the first layer;

a junction layer adjacent the first semiconductor layer;

a second semiconductor nitride layer adjacent the junction layer;

a second contact adjacent to the second semiconductor layer and in electrical communication with the second layer;

wherein the first and second contacts are electrically interconnected through the junction layer. The first and second contacts may be electrically interconnected via the junction layer.

According to an arrangement of the second aspect there is provided a semiconductor device formed from semiconductor nitride materials comprising:

a substrate;

at least one first contact on the substrate;

a first semiconductor nitride layer wherein the first contact is buried in the first layer and in electrical communicationwith the first layer;

a junction layer deposited on or adjacent to the first semiconductor layer;

a second semiconductor nitride layer adjacent the junction layer;

a second contact adjacent to the second semiconductor layer and in electrical communication with the second layer;

wherein the first and second contacts are electrically interconnected through the junction layer. By "electrically interconnected through the junction layer", it is meant that the first and second contacts are electrically interconnected via the junction layer rather than being directly connected to one another.

According to a third aspect there is provided a semiconductor nitride device comprising:

a substrate;

a first metal nitride layer deposited on the substrate;

at least a first contact formed on the first metal nitride film;

a second metal nitride layer deposited on the first metal nitride layer encapsulating at least a portion of the first contact;

a semiconductor junction region deposited on the second metal nitride layer;

a third metal nitride layer deposited on the junction region, the third metal nitride layer having opposite semiconductor doping polarity to that of the first and second metal nitride layers; and

a second contact in electrical communication with the third metal nitride layer.

According to an arrangement of the third aspect, there is provided According to a third aspect there is provided a semiconductor nitride device comprising:

a substrate;

a first metal nitride layer deposited on the substrate;

at least a first contact formed on the first metal nitride film;

a second metal nitride layer deposited on the first metal nitride layer encapsulating at least a portion of the first contact;

a semiconductor junction region deposited on or adjacent to the second metal nitride layer;

a third metal nitride layer deposited on the junction region, the third metal nitride layer having opposite semiconductor doping polarity to that of the first and second metal nitride layers; and

a second contact in electrical communication with the third metal nitride layer.

The metal nitride layers of each of the first to third aspects may be formed from a metal nitride semiconductor material for example GaN, AlGaN, InGaN, InGaAlN, InAlN or cmbinations therof for example InGaN/AlGaN, InGaN/GaN, GaN/AlGaN, GaN/AlInGaN, InGaN/AlInGaN, AlGaN/AlInGaN among others as would be appreciated by the skilled addressee.

In each of the devices of the first to the third aspects, the first contact may be on or adjacent the substrate, or alternatively may be on, adjacent, embedded or buried within a conducting buffer layer, wherein the conducting buffer layer may be on or adjacent the substrate. The encapsulating of at least a portion of the first contact may comprise forming at least a partly embedded or at least partly buried contact.

In each of the devices of the first to the third aspects, each of the first and the second contacts may be conducting contacts, and may be metal contacts. The conducting contact(s) may have a resistivity that is much less than that of the metal nitride semiconductor material, for example the resistivity of the contact(s) may be one, two, three, four, five, six, seven, eight or more orders of magnitude less than the resistivity of the metal nitride semiconductor material.

In each of the devices of the first to the third aspects, the photoluminescence of the device at or about the wavelength corresponding to the intrinsic band gap(s) (either direct or indirect band-gap(s)) of materials used in the device may exceed the photo luminescence of the device at other wavelengths. The other wavelengths may correspond to photoluminescence from defects within the device. For example, for a metal nitride semiconductor (e.g. GaN or similar semiconductor material as described herein) the wavelength corresponding to the band-gap may be in the range of about 300 to 550 nm, or alternatively about 300 to 500, 300 to 450, 320 to 550, 320 to 500, 320 to 450, 340 to 450, 360 to 450, 360 to 420, 360 to 400 nm and may be about 300, 310, 320, 330, 340, 350, 360, 370, 380, 390, 400, 410, 420, 430, 440, or about 450 nm and the photoluminescence at this wavelength may exceed the maximum intensity of the defect-related photoluminescence in the wavelength range of about 450 to 800 nm. The intensity of the photoluminescence at the band-gap wavelength may exceed the intensity of the photoluminescence at other (e.g. defect-related) wavelengths by a factor of at least 0.5 1, 1.5, 2 or more.

According to a fourth aspect there is provided a process of forming a semiconductor device having embedded contacts comprising the steps of:

forming first at least one contact on a substrate;

masking the first contact to expose at least one device region;

forming a first layer over the first contact in the vicinity of the device region to embed the first contact within the first layer;

forming a junction over the first layer;

forming a second layer over the junction;

forming a second contact on the second layer; and

removing the mask to expose the first contacts on the substrate in a region not corresponding to the device regions.

According to an arrangement of the fourth aspect there is provided a process of forming a semiconductor device having buried contacts comprising the steps of:

forming first at least one contact on a substrate;

masking the first contact to expose at least one device region;

forming a first layer over the first contact in the vicinity of the device region to bury the first contact within the first layer;

forming a junction over the first layer;

forming a second layer over the junction;

forming a second contact on the second layer; and

removing the mask to expose the first contacts on the substrate in a region not corresponding to the device regions.

According to a further arrangement of the fourth aspect there is provided a process of forming a semiconductor device having embedded or buried contacts comprising the steps of:

providing a substrate comprising at least one first conducting contact;

masking the first contact to expose at least one device region;

forming a first layer over the first contact in the vicinity of the device region to embed or bury the first contact within the first layer;

forming a junction over the first layer;

forming a second layer over the junction;

forming a second conducting contact on the second layer; and

removing the mask to expose the first contacts on the substrate in a region not corresponding to the device regions.

The first and second contact(s) may be respectively first and second conducting contact(s), and may be respectively first and second metal contact(s). The first conducting contact(s) and the second conducting contact may be metal contacts.

According to a fifth aspect there is provided a process of forming an embedded contact semiconductor nitride device comprising the steps of:

providing a substrate comprising at least one first contact;

masking a first portion of the first contact to expose at least one device region comprising a second portion of the first contact;

forming a first semiconductor nitride layer over the second portion of the first contact in the device region thereby to embed the first contact within the first layer;

forming a junction over the first layer;

forming a second semiconductor nitride layer over the junction;

forming a second contact on the second layer; and

removing the mask thereby exposing the first portion of the first contacts.

According to an arrangement of the fifth aspect there is provided a process of forming an buried contact semiconductor nitride device comprising the steps of:

forming first at least one conducting contact on a substrate;

masking a first portion of the first contact to expose at least one device region comprising a second portion of the first contact;

forming a first semiconductor nitride layer over the second portion of the first contact in the device region thereby to bury the first contact within the first layer;

forming a junction over the first layer;

forming a second semiconductor nitride layer over the junction;

forming a second conducting contact on the second layer; and

removing the mask thereby exposing the first portion of the first contacts.

According to an arrangement of the fifth aspect there is provided a process of forming an embedded or buried contact semiconductor nitride device comprising the steps of:

providing a substrate comprising at least one conducting contact;

masking a first portion of the first contact to expose at least one device region comprising a second portion of the first contact;

forming a first semiconductor nitride layer over the second portion of the first contact in the device region thereby to embed or bury the first contact within the first layer;

forming a junction over the first layer;

forming a second semiconductor nitride layer over the junction;

forming a second conducting contact on the second layer; and

removing the mask thereby exposing the first portion of the first contacts.

The first and second contact(s) may be respectively first and second conducting contact(s), and may be respectively first and second metal contact(s). The first conducting contact(s) and the second conducting contact may be metal contacts.

According to a sixth aspect there is provided a process of forming an embedded contact semiconductor nitride device comprising the steps of:

providing a substrate comprising at least one first conducting contact;

forming a first semiconductor nitride layer over the first contact thereby to embed the first contact within the first layer;

forming a junction over the first layer;

forming a second semiconductor nitride layer over the junction; and

forming a second conducting contact on the second layer.

According to an arrangement of the sixth aspect there is provided a process of forming an buried contact semiconductor nitride device comprising the steps of:

forming first at least one conducting contact on a substrate;

forming a first semiconductor nitride layer over the first contact thereby to bury the first contact within the first layer;

forming a junction over the first layer;

forming a second semiconductor nitride layer over the junction; and

forming a second conducting contact on the second layer.

According to an arrangement of the sixth aspect there is provided a process of forming an embedded or buried contact semiconductor nitride device comprising the steps of:

providing a substrate comprising at least one first conducting contact;

forming a first semiconductor nitride layer over the first contact thereby to embed or bury the first contact within the first layer;

forming a junction over the first layer;

forming a second semiconductor nitride layer over the junction; and

forming a second conducting contact on the second layer.

A process of the invention of any one of the fourth to the sixths aspects may be carried out such that the semiconductor layers of the device may be prepared at a temperature not exceeding about 800°C or in other arrangements, not greater than at a temperature exceeding about 700°C. The semiconductor layers of the device may be prepared at one or more temperature(s) within the range of about 500°C to about 800°C or alternatively in the range of about 500°C to about 700°C.

The metal nitride layers of each of the fourth to sixth aspects may be formed from a metal nitride semiconductor material for example GaN, AlGaN, InGaN, InGaAlN, InAlN or cmbinations therof for example InGaN/AlGaN, InGaN/GaN, GaN/AlGaN, GaN/AlInGaN, InGaN/AlInGaN, AlGaN/AlInGaN among others as would be appreciated by the skilled addressee.

In each of the devices of the fourth to sixth aspects, each of the first and the second contacts may be conducting contacts, and may be metal contacts. The first conducting contact(s) and the second conducting contact may be metal contacts. The conducting contact(s) may have a resistivity that is much less than that of the metal nitride semiconductor material, for example the resistivity of the contact(s) may be one, two, three, four, five, six, seven, eight or more orders of magnitude less than the resistivity of the metal nitride semiconductor material.

Each of the processes of the fourth to sixth aspects may comprise forming the first and second semiconductor nitride layers at a temperature in the range of approximately 500 to 800 degrees Celsius, or about 500°C to 700°C. Each process may optionally comprise the step of depositing a buffer layer which may be either an insulating buffer layer or a doped buffer layer. The doped buffer layer may be either n-type or p-type. The buffer layer may be deposited on the substrate prior to forming the at least one first metal contact, wherein the first contacts are formed on the buffer layer. The first contact may be an electrical contact. The first contact may form an ohmic contact with the first layer. The first contact may form an ohmic contact with a conducting buffer layer. The combination of the first contact and the buffer layer may form an ohmic contact with the first layer. The electrical communication may be in the form of an ohmic contact. The buffer layer may be deposited on the substrate after the forming of the at least one first metal contact, wherein the first contacts are embedded within the buffer layer. The buffer layer may be a series resistance lowering buffer layer. The buffer layer may be an active semiconductor buffer layer and may be an active semiconductor nitride layer. The buffer layer may be formed from ZnO or other suitable materials. In each of the first to the sixth aspects, the junction layer is in electrical communication with both the first and the second layers of the device

The invention also includes a device obtainable by a process of the invention. Also within the scope of the invention is a device formed by a process of the invention.

The first layer may be a first semiconductor layer and may be a first metal nitride semiconductor layer. The first metal nitride semiconductor layer may be either n-type or p-type. The junction may be a double heterostructure junction. The double heterostructure junction may be formed from InGaN and or AlGaN metal nitrides. The junction may be a single or multi-quantum well junction or some other type of semiconductor junction. The semiconductor layers may be formed by a remote plasma fabrication technique under nitrogen atmosphere.

In an arrangement of each of the first to third aspects of the semiconductor device or in any one of the processes of the fourth to sixth aspects, the junction layer may be a junction region in either the first or second semiconductor layers. Similarly, one or both the first and second semiconductor layers may independently or each be defined by regions of doping in a suitable semiconductor material.

A semiconductor device of the invention may be prepared such that the semiconductor layers of the device may be formed at a temperature not exceeding about 800°C or in other arrangements, not greater than at a temperature exceeding about 700°C. It may be prepared at one or more temperature(s) within the range of about 500°C to about 700°C.

In an arrangement of each of the first to third aspects of the semiconductor device or in any one of the processes of the fourth to sixth aspects, the following features apply alone or in any combination of two or more features:

The first contact may be embedded within a buffer layer, which may be a conducting buffer layer. In other arrangements of the semiconductor device, the first contact may be situated on top of the buffer layer. In further arrangements, the first contact may be embedded within the first layer. In other arrangements, the semiconductor device may comprise a buffer layer intermediate the substrate and the first layer. The first contact may be embedded within the buffer layer or the first layer. The first contact may be an electrical contact. The first contact may form an ohmic contact with the first layer. The first contact may form an ohmic contact with a conducting buffer layer. The combination of the first contact and the buffer layer may form an ohmic contact with the first layer. The electrical communication may be in the form of an ohmic contact. There may be more than one buffer layer, for example there may be two, three, four or five or more buffer layers. The buffer layer may be an active semiconductor buffer layer and may be an active semiconductor nitride layer. The buffer layer may be formed from ZnO. The buffer layer may be a series resistance lowering buffer layer.

The first layer may be an n-type semiconductor layer and the second layer a p-type semiconductor layer. In other arrangements the first layer may be a p-type semiconductor layer and the second layer an n-type semiconductor layer. The first and second layers may each be lightly-doped or they may each be heavily doped. In other arrangements the first layer may be lightly-doped and the second layer may be heavily-doped or alternatively the first layer may be heavily- doped and the second layer may be lightly-doped. Either the first or second layers may include stepped or gradient regions of doping where the doping changes from lightly-doped to heavily-doped or vice-versa. The n-type layer may be a gallium-rich nitride layer and may be a nitride layer doped with silicon. The p-type layer may be a nitride layer doped with magnesium, and may be a gallium nitride layer doped with magnesium. Alternatively the p-type layer may be a nitride layer doped with beryllium, or zinc.

The first and/or second layers may have a doping concentration of between $1 \times 10^{18}$ cm$^{-3}$ to $1 \times 10^{19}$ cm$^{-3}$, or the doping concentration may be in the range of $1 \times 10^{16}$ cm$^{-3}$ to $1 \times 10^{21}$ cm$^{-3}$, $1 \times 10^{17}$ cm$^{-3}$ to $1 \times 10^{20}$ cm$^{-3}$, $5 \times 10^{17}$ cm$^{-3}$ to $1 \times 10^{20}$ cm$^{-3}$, $1 \times 10^{18}$ cm$^{-3}$ to $1 \times 10^{20}$ cm$^{-3}$, $1 \times 10^{18}$ cm$^{-3}$ to $5 \times 10^{19}$ cm$^{-3}$, $5 \times 10^{18}$ cm$^{-3}$ to $5 \times 10^{19}$ cm$^{-3}$, $2 \times 10^{18}$ cm$^{-3}$ to $1 \times 10^{19}$ cm$^{-3}$, or $5 \times 10^{18}$ cm$^{-3}$ to $1 \times 10^{19}$ cm$^{-3}$. The doping concentration may be approximately $1 \times 10^{16}$ cm$^{-3}$, $5 \times 10^{16}$ cm$^{-3}$, $1 \times 10^{17}$ cm$^{-3}$, $5 \times 10^{17}$ cm$^{-3}$, $8 \times 10^{17}$ cm$^{-3}$, $1 \times 10^{18}$ cm$^{-3}$, $2 \times 10^{18}$ cm$^{-3}$, $3 \times 10^{18}$ cm$^{-3}$, $4 \times 10^{18}$ cm$^{-3}$, $5 \times 10^{18}$ cm$^{-3}$, $6 \times 10^{18}$ cm$^{-3}$, $7 \times 10^{18}$ cm$^{-3}$, $8 \times 10^{18}$ cm$^{-3}$, $9 \times 10^{18}$ cm$^{-3}$, $1 \times 10^{19}$ cm$^{-3}$, $1 \times 10^{19}$ cm$^{-3}$, $2 \times 10^{19}$ cm$^{-3}$, $5 \times 10^{19}$ cm$^{-3}$ or $1 \times 10^{20}$ cm$^{-3}$. The first layer may be more heavily doped adjacent the first contact.

The semiconductor device may be a metal nitride semiconductor device. The first and second layers may be formed from a III-V semiconductor material. The first and second layers may be formed from a metal nitride. The metal nitride may be Gallium Nitride (GaN). In other arrangements the first and second layers may be formed of Aluminium GaN (AlGaN), Indium GaN (InGaN), InGaAlN, or InAlN. In further arrangements, the first and second layers may be formed from different semiconductor materials for example InGaN/AlGaN, InGaN/GaN, GaN/AlGaN, GaN/AlInGaN, InGaN/AlInGaN, AlGaN/AlInGaN, or other combinations thereof. In further arrangements multiple layers may be used at the junction, such as InGaN quantum wells, or layers, sandwiched between GaN or AlGaN barriers. The semiconductor device may form a semiconductor transistor for example a bipolar junction transistor, field-effect transistor among many others. The semiconductor device may form a light emitting device for example a light emitting diode, a laser device for example a laser diode (either an edge-emitting laser diode or vertical-cavity surface emitting laser VCSEL, or some other type of laser diode) and may for example be an InGaN/GaN laser diode. The light emitting device may emit light within a wavelength range of about 300 to 600 nm. The light emitting device may be a GaN blue LED, a GaN based blue LED, a GaN based blue laser diode or a GaN blue laser diode. The semiconductor device may form a light detecting device for example a photodiode, phototransistor, charge-coupled device, solar cells or solar-blind detector among many others. The light detecting device may detect light in the wavelength range of about 350 to 700 nm.

The first contact may be an n-type contact and the second contact may be a p-type contact. In other arrangements the first contact may be a p-type contact and the second contact may be an n-type contact.

The distance between the first and second contact may be in the range of approximately 10 nm to 10,000 nm. Alternatively the distance between the first and second contact may 10 nm to 5, 000 nm, 10 to 1,000, 10 to 900, 10 to 800, 10 to 700, 10 to 600, 10 to 500, 10 to 400, 10 to 350, 10 to 300, 10 to 250, 10 to 200, 10 to 150, 10 to 100, 10 to 50, 50 to 10,000, 50 to 5,000, 50 to 1,000, 50 to 750, 50 to 500, 50 to 300, 100 to 10,000, 100 to 5,000, 100 to 1,000, 100 to 750, 100 to 600, 100 to 500, 100 to 450, 100 to 300, 100 to 350, 100 to 300, 100 to 250, 100 to 200, 100 to 150, 200 to 10,000, 200 to 5,000, 200 to 1,000, 200 to 750, 200 to 600, 200 to 500, 200 to 450, 200 to 300, 200 to 350, 200 to 300, 200 to 250, 400 to 10,000, 400 to 5,000, 400 to 1,000, 400 to 750, 400 to 600, 400 to 500, 400 to 450, 1,000 to 10,000, 1,000 to 7,500, 1,000 to 5,000, 1,000 to 2,500, 1,000 to 2,000, 2,500 to 10,000, or 5,000 to 10,000 nm and the distance between the first and second contact may be approximately 10 nm, or 50, 100, 150, 200, 250, 300, 350, 400, 450, 500, 550, 600, 650, 700, 750, 800, 900, 1,000, 1,500, 2,000, 2,500, 3,000, 3,500, 4,000, 4,500, 5,000, 6,000, 7,000, 8,000, 9,000, or 10,000 nm.

The series resistance in the layer adjacent the first contact (i.e. the buried contact, in both n-type or p-type configurations) may be less than 5 ohms and may be in the range of about 0.00001 to 5 ohms. Alternatively the series resistance may be in the range of about 0.0001 to 2, 0.0001 to 1, 0.0001 to 0.1, 0.0001 to 0.01, 0.0001 to 0.001, 0.001 to 5, 0.001 to 2, 0.001 to 1, 0.001 to 0.1, 0.001 to 0.01, 0.01 to 5, 0.01 to 2, 0.01 to 1, 0.01 to 0.1, 0.1 to 5, 0.1 to 2, 0.1 to 1, and may be about 0.0001, 0.0005, 0.001, 0.002, 0.003, 0.004, 0.005, 0.006, 0.007, 0.008, 0.009, 0.01, 0.02, 0.03, 0.04, 0.05, 0.06, 0.07, 0.08, 0.09, 0.1, 0.2, 0.3, 0.4, 0.5, 0.6, 0.7, 0.8, 0.9, 1 2, or approximately 5 ohms.

The substrate may be sapphire, glass, for example borosilicate or silica glass, quartz, ZnO, silicon carbide, silicon or other suitable substrate.

The semiconductor device may comprise at least one additional first contact embedded in the device and spaced from the first contact. The semiconductor device may alternatively comprise a plurality of additional first contacts embedded in the device. The spacing between a first contact and an adjacent additional first contact may be within the range of approximately 50 $\mu$m to 1,000 $\mu$m, or alternatively may be within the range of approximately 50 to 750, 50 to 500, 50 to 450, 50 to 400, 50 to 350, 50 to 300, 50 to 250, 50 to 200, 50 to 150, 50 to 100, 100 to 1,000, 100 to 750, 100 to 500, 100 to 450, 100 to 400, 100 to 350, 100 to 300, 100 to 250, 100 to 200, 100 to 150, 250 to 500, 250 to 450, 250 to 400, 250 to 350, or 250 to 300 $\mu$m and the spacing may be approximately 50, 75, 100, 125, 150, 175, 200, 225, 250, 275, 300, 325, 350, 375, 400, 450, 500, 600, 700, 800, 900, or 1,000 $\mu$m.

The junction region may comprise a simple p-n, n-p, p-n-p or n-p-n junction, or, in other arrangements the junction region may be a double heterostructure junction, a single quantum well junction or a multi-quantum well junction. The junction region may comprise a multi-quantum well junction with 2, 3, 4, 5, 6, 7, 8, 9, 10 or more quantum wells contained therein. There may be more than one junction region, for example there may be two, three, four, five six, seven, eight, nine, or ten or more junction regions. The junction region may comprise a region of the device having a depletion region or zone as would be appreciated by the skilled addressee and may comprise one -, two -, or three - eight or more layers within the device, wherein the layers may be selected from one or more of a semiconductor layer, a metal nitride semiconductor layer, a buffer layer, or a conducting buffer layer. One or more of the layers of the semiconductor device and/or the junction region may be a doped region of a semiconductor material or may be formed by doping the semiconductor material with a dopant for example by diffusion of the dopant into the semiconductor material or other suitable methods as would be appreciated by the skilled addressee. The junction region may alternatively be formed by depositing or forming one or more semiconductor layers on the semiconductor material and/or the doped semiconductor material.

Electrically interconnected, and being in electrical communication as described above comprises the first and second contacts being in indirect electrical contact via the junction layer of the device as opposed to being in direct electrical contact with each other.

The first contact may extend beyond the semiconductor device to facilitate forming an electrical contact therewith. The substrate, the buffer layer, or the first layer or a combination thereof may extend beyond the semiconductor device to support the extended first contact. For instance, a portion of the embedded or buried contact may be exposed to enable electrical contact to be made thereto, or, the embedded or buried contact (or a portion thereof) may extend beyond the layer within which it is embedded or buried to enable electrical contact to be made thereto.

## BRIEF DESCRIPTION OF THE DRAWINGS

A preferred embodiment of the present invention will now be described, by way of an example only, with reference to the accompanying drawings wherein:

**Figure 1** is an example of a prior art mesa structure semiconductor device having external contacts;

**Figure 2** is a first arrangement of a buried contact semiconductor device;

**Figure 3** is a second arrangement of a buried contact semiconductor device;

**Figure 4** is a third arrangement of a buried contact semiconductor device;

**Figure 5** is a fourth arrangement of a buried contact semiconductor device;

**Figure 6** is a fifth arrangement of a buried contact semiconductor device;

**Figure 7** is a flow chart depicting a first arrangement of a process for forming a buried contact semiconductor device;

**Figure 8** is a flow chart depicting a second arrangement of a process for forming a buried contact semiconductor device;

**Figures 9A, 10A, 11A** and **12A** are respectively top plan views of a semiconductor device during the initial processing stages of the process of **Figure 7;**

**Figures 9B, 10B, 11B** and **12B** are respectively cross-sectional plan views of a semiconductor device during the initial processing stages respectively taken along lines *B - B, C - C, D* - D and *E - E* of **Figures 9A, 10A, 11A** and **12A** respectively; and

**Figure 13** is a graph of the photoluminescence from a double heterostructure junction formed according to the process of the invention.

**DETAILED DESCRIPTION OF THE PREFERRED EMBODIMENTS**

Disclosed herein are metal nitride semiconductor devices and apparatus having embedded/buried contacts. The advantage of such devices include significantly reduced series resistance between the electrical contacts of the device thereby providing enhanced operational efficiency and reduced heating of the device. Further advantages of embedded contacts in metal nitride semiconductor devices include; if a portion of the buried contacts can be kept free of deposition then the need for photolithography to produce such a device can be eliminated. A mask can be used to eliminate deposition on a contact surface. The fabrication of wider area devices might be possible, depending upon other operational constraints, such as current, voltage and heat dissipation.

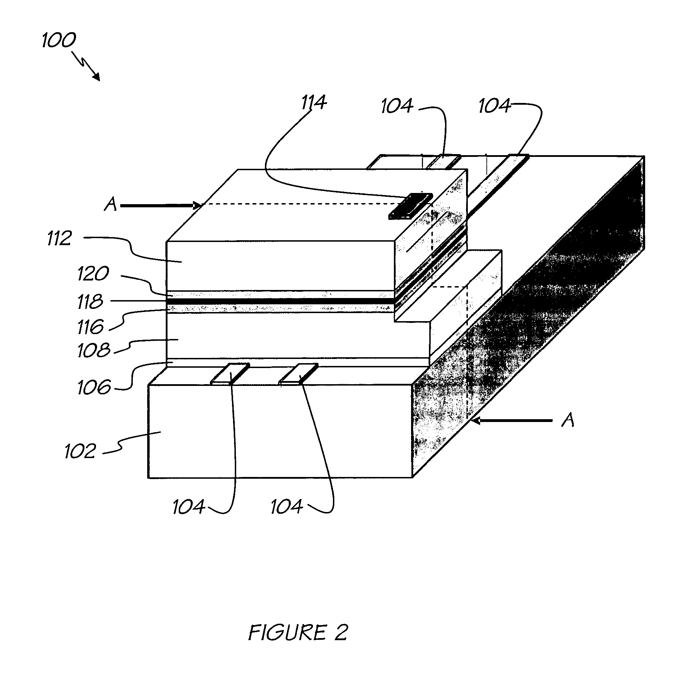

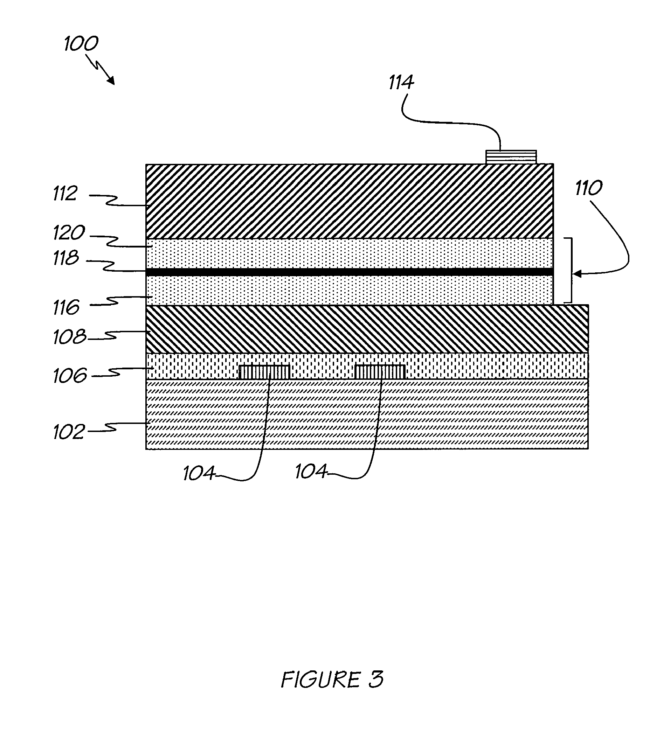

Referring to the **Figure 2** of the drawings, there is provided a metal nitride semiconductor device **100** shown in a three-dimensional view and in **Figure 3** in cross-sectional view along dotted line A-A of **Figure 2.** The semiconductor device comprises a substrate **102,** first contacts **104,** a conducting buffer layer **106,** a first layer **108** of doped semiconductor material deposited on the buffer layer **106,** a semiconductor junction region **110** deposited on the first layer **108,** a second layer **112** of doped semiconductor material deposited on the junction region **110,** the second layer **112** having opposite semiconductor doping polarity to that of the first layer **108;** and a second contact **114,** wherein the second contact **114** is in electrical communication with the second layer **112** and the first contacts **104** are embedded within the semiconductor device **100** between the substrate **102** and the junction region **110.** In the particular arrangement shown, the first contacts are embedded within the buffer layer **102** although arrangements, the first contacts **104** may be situated on top of the buffer layer **102.** In further arrangements still, the second contact may be embedded within the first layer of semiconductor material **106.**

The first layer **106** may be an n-type semiconductor layer and the second layer **112** a p-type semiconductor layer. In other arrangements the first layer **102** may be an p-type semiconductor layer and the second layer **112** an n-type semiconductor layer. The first and second layers may each be lightly-doped or they may each be heavily doped. In other arrangements the first layer may be lightly-doped and the second layer may be heavily-doped or alternatively the first layer may be heavily- doped and the second layer may be lightly-doped. Either the first or second layers may include stepped or gradient regions of doping where the doping changes from lightly-doped to heavily-doped or vice-versa (not shown). The first layer may be more heavily doped adjacent the first contact. The first layer may have a doping concentration of between $1 \times 10^{18}$ cm$^{-3}$ to $1 \times 10^{19}$ cm$^{-3}$, or the doping concentration may be in the range of $1 \times 10^{16}$ cm$^{-3}$ to $1 \times 10^{21}$ cm$^{-3}$, $1 \times 10^{17}$ cm$^{-3}$ to $1 \times 10^{20}$ cm$^{-3}$, $5 \times 10^{17}$ cm$^{-3}$ to $1 \times 10^{20}$ cm$^{-3}$, $1 \times 10^{18}$ cm$^{-3}$ to $1 \times 10^{20}$ cm$^{-3}$, $1 \times 10^{18}$ cm$^{-3}$ to $5 \times 10^{19}$ cm$^{-3}$, $5 \times 10^{18}$ cm$^{-3}$ to $5 \times 10^{19}$ cm$^{-3}$, $2 \times 10^{18}$ cm$^{-3}$ to $1 \times 10^{19}$ cm$^{-3}$, or $5 \times 10^{18}$ cm$^{-3}$ to $1 \times 10^{19}$ cm$^{-3}$. The doping concentration may be approximately $1 \times 10^{16}$ cm$^{-3}$, $5 \times 10^{16}$ cm$^{-3}$, $1 \times 10^{17}$ cm$^{-3}$, $5 \times 10^{17}$ cm$^{-3}$, $8 \times 10^{17}$ cm$^{-3}$, $1 \times 10^{18}$ cm$^{-3}$, $2 \times 10^{18}$ cm$^{-3}$, $3 \times 10^{18}$ cm$^{-3}$, $4 \times 10^{18}$ cm$^{-3}$, $5 \times 10^{18}$ cm$^{-3}$, $6 \times 10^{18}$ cm$^{-3}$, $7 \times 10^{18}$ cm$^{-3}$, $8 \times 10^{18}$ cm$^{-3}$, $9 \times 10^{18}$ cm$^{-3}$, $1 \times 10^{19}$ cm$^{-3}$, $1 \times 10^{19}$ cm$^{-3}$ $2 \times 10^{19}$ cm$^{-3}$, $5 \times 10^{19}$ cm$^{-3}$ or $1 \times 10^{20}$ cm$^{-3}$.

The semiconductor device **100** may be a metal nitride semiconductor device. The first and second layers **108** and **112** are formed from a III-V metal nitride semiconductor material such as Gallium Nitride (GaN). In other arrangements the first and second layers **108** and **112** are formed of Aluminium GaN (AlGaN), Indium GaN (InGaN), InGaAlN, or InAlN. In further arrangements, the first and second layers **108** and **112** are formed from different semiconductor materials for example InGaN/AlGaN, InGaN/GaN, GaN/AlGaN, GaN/AlInGaN, InGaN/AlInGaN, AlGaN/AlInGaN or other combinations thereof.

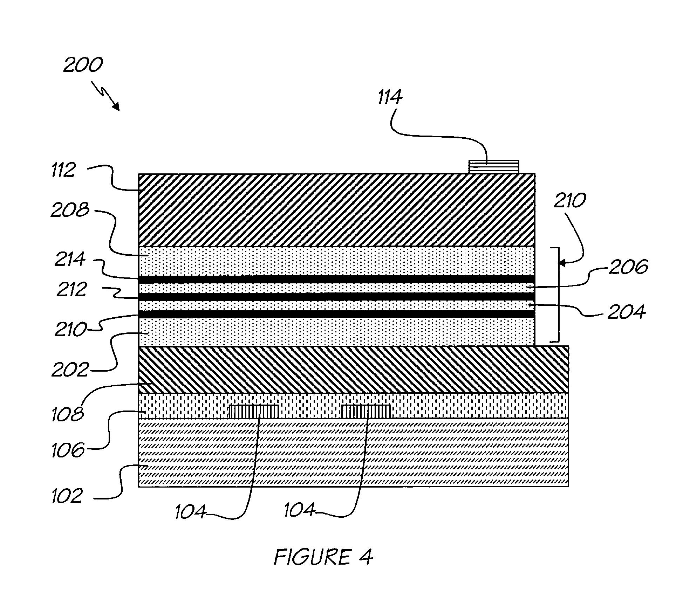

The junction **110** of **Figures 2** and **3** are depicted as a double heterostructure junction comprising a first junction layer **116** of an n- or p-type semiconductor material such as for example either AlGaN, an intermediate layer **118** for example of InGaN, and a second junction layer **120** of opposite doping polarity (i.e. p- or n-type respectively) to that of the first junction layer in accordance with common heterostructure junctions. In other arrangements, the semiconductor device may be a single or multi-quantum well device. **Figure 4** (where like elements are indicated with like reference numerals) shows an example arrangement of a metal nitride semiconductor device with embedded contacts, wherein the junction region **210** comprises a 2-quantum well structure. The junction buffer layers **202** and **208** and the quantum well layers **204** and **206** may be formed from either an n- or p-type doped material formed from InGaN or AlGaN, with intermediate layers **210, 212** and **214** forming the barriers of the well structures being formed from, for example GaN or AlGaN, in accordance with common multi-quantum well structures. The intermediate layers **210, 212** and **214** may have a substantially similar band gap to that of either junction layer **106** or **112** as required, or the band gap may be different, provided that it is sufficiently larger than the band gap of the well layers **204** and **206.** In other arrangements, the semiconductor device may have 3, 4, 5 or more quantum well layers as required.

The first contacts **104** may be an n-type contact and the second contact **114** may be a p-type contact. In other arrangements the first contact **104** is a p-type contact and the second contact **114** is an n-type contact.

The distance between the first **104** and second **114** contacts may be in the range of approximately 10 nm to 10,000 nm. Alternatively the distance between the first and second contact may 10 nm to 5, 000 nm, 10nm to 1,000 nm, 10 nm to 900 nm, 10 nm to 800 nm, 10 nm to 700 nm, 10 nm to 600 nm, 10 nm to 500 nm, 10 nm to 400 nm, 10 nm to 350 nm, 10 nm to 300 nm, 10 nm to 250 nm, 10 nm to 200 nm, 10 nm to 150 nm, 10 nm to 100 nm, 10 nm to 50 nm, 50 nm to 10,000 nm, 50 nm to 5,000 nm, 50 nm to 1,000 nm, 50 nm to 750 nm, 50 nm to 500 nm, 50 nm to 300 nm, 100 nm to 10,000 nm, 100 nm to 5,000 nm, 100 nm to 1,000 nm, 100 nm to 750 nm, 100 nm to 600 nm, 100 nm to 500 nm, 100 nm to 450 nm, 100 nm to 300 nm, 100 nm to 350 nm, 100 nm to 300 nm, 100 nm to 250 nm, 100 nm to 200 nm, 100 nm to 150 nm, 1,000 nm to 10,000 nm, 1,000 nm to 7,500 nm, 1,000 nm to 5,000 nm, 1,000 nm to 2,500 nm, 1,000 nm to 2,000 nm, 2,500 nm to 10,000 nm, or 5,000 nm to 10,000 nm and the distance between the first and second contact may be approximately 10 nm, or 50, 100, 150, 200, 250, 300, 350, 400, 450, 500, 550, 600, 650, 700, 750, 800, 900, 1,000, 1,500, 2,000, 2,500, 3,000, 3,500, 4,000, 4,500, 5,000, 6,000, 7,000, 8,000, 9,000, or 10,000 nm.

The semiconductor device may comprise at least one additional first contact embedded in the device and spaced from the first contact. The spacing between the first contact and an additional first contact may be within the range of approximately 50 $\mu$m to 1,000 $\mu$m, or alternatively may be within the range of approximately 50 $\mu$m to 750 $\mu$m, 50 $\mu$m to 500 $\mu$m, 50 $\mu$m to 450 $\mu$m, 50 $\mu$m to 400 $\mu$m, 50 $\mu$m to 350 $\mu$m, 50 $\mu$m to 300 $\mu$m, 50 $\mu$m to 250 $\mu$m, 50 $\mu$m to 200 $\mu$m, 50 $\mu$m to 150 $\mu$m, 50 $\mu$m to 100 $\mu$m, 100 $\mu$m to 1,000 $\mu$m, 100 $\mu$m to 750 $\mu$m, 100 $\mu$m to 500 $\mu$m, 100 $\mu$m to 450 $\mu$m, 100 $\mu$m to 400 $\mu$m, 100 $\mu$m to 350 $\mu$m, 100 $\mu$m to 300 $\mu$m, 100 $\mu$m to 250 $\mu$m, 100 $\mu$m to 200 $\mu$m, 100 $\mu$m to 150 $\mu$m, 250 $\mu$m to 500 $\mu$m, 250 $\mu$m to 450 $\mu$m, 250 $\mu$m to 400 $\mu$m, 250 $\mu$m to 350 $\mu$m, or 250 $\mu$m to 300 $\mu$m and the spacing may be approximately 50, 75, 100, 125, 150, 175, 200, 225, 250, 275, 300, 325, 350, 375, 400, 450, 500, 600, 700, 800, 900, or 1,000 $\mu$m.

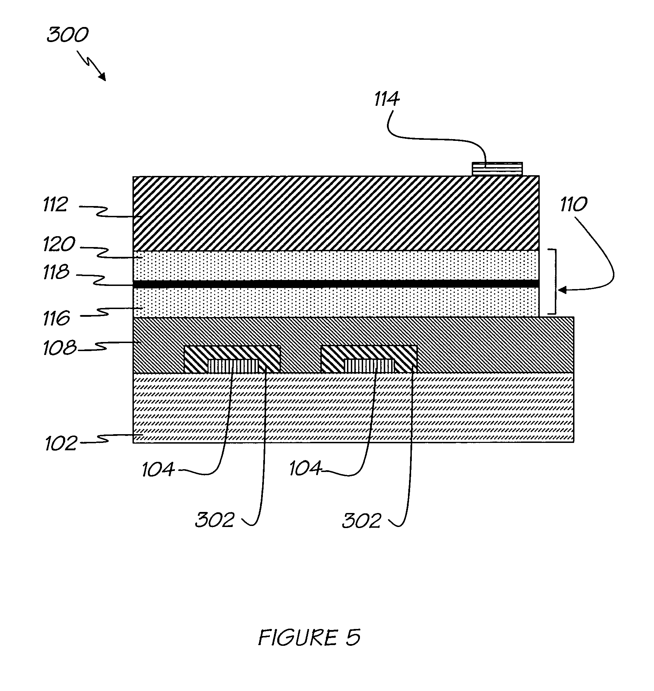

As depicted in **Figure 2,** the first contacts **104** extend beyond the buffer layer **106** and the semiconductor device layers **108** to **112** to facilitate forming an electrical contact therewith. The first contacts **104** may, in other arrangements such as for example that depicted in **Figure 5** (where like elements are indicated with like reference numerals), be formed within either the first layer, and may comprise a region of heavier doped semiconductor material **302** in the vicinity of the contacts **104** to provide enhanced electrical contact with the device. The substrate, the buffer layer, or the first layer or a combination thereof may extend beyond the semiconductor device to support the extended first contact as required as depicted in **Figure 2.**

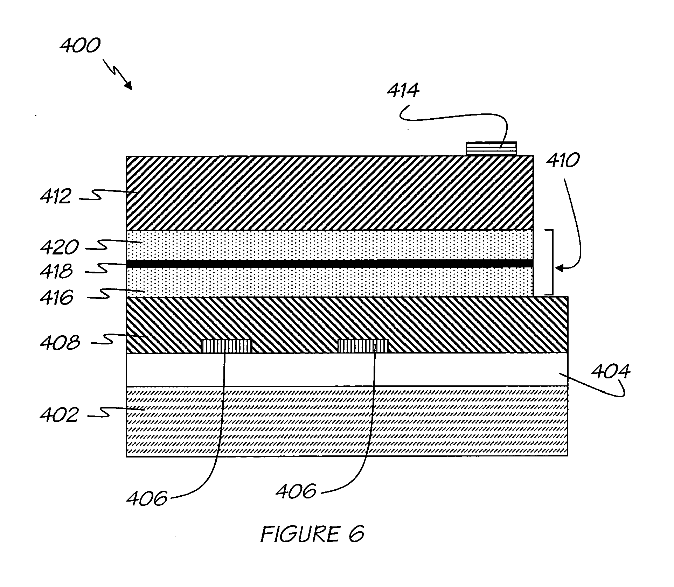

A further arrangement of a metal nitride semiconductor device with embedded/buried contacts is depicted in **Figure 6** comprising a substrate **402,** a first metal nitride layer **404** deposited on the substrate, at least a first contact **406** formed on the first metal nitride film **404,** a second metal nitride layer **408** deposited on the first metal nitride layer **404** encapsulating at least a portion of the first contact **406,** a semiconductor junction region **410** deposited on the second metal nitride layer **408** a third metal nitride layer **412** deposited on the junction region **410,** the third metal nitride layer **412** having opposite semiconductor doping polarity to that of the first and second metal nitride layers **402** and **408** respectively, and a second contact **414** in electrical communication with the third metal nitride layer **412**. As for **Figure 3, Figure 6** is depicted as a double heterostructure junction with a first junction layer **416** of an n- or p-type semiconductor material such as for example either AlGaN, an intermediate layer **418** for example of InGaN, and a second junction layer **420** of opposite doping polarity (i.e. p- or n-type respectively) to that of the first junction layer in accordance with common heterostructure junctions, although other junction architecture is also possible in further arrangements

The series resistance of the semiconductor device structures as described above with embedded metal contacts are significantly smaller than mesa structure semiconductor devices such as those depicted in **Figure 1.** For example, for the case where the n-contact is only along one side of the LED mesa structure the resistance R of the n-spreading layer is given by

$$R = \rho_{sn} \bullet (L_{sp} + \lambda)/L \qquad\qquad (1)$$

where $\rho_{sn}$ is the sheet resistivity of the n-type layer, $L_{sp}$ is the spreading length of the n-layer, $\lambda$ is the distance between the n-contact and the mesa structure, and L is the width of a square mesa structure. Taking typical values for the variables in equation (1) (for example, those provided in Chakraborty et al. IEEE Transactions of Electron Devices v. 54, No. 5 2007) the typical resistance of a mesa structure device is approximately 13 ohms. In comparison, for a structure where the n- contact is directly below the top p-contact, the equivalent resistance $R_{bc}$ of the buried contact device (for example a device similar to that depicted in **Figure 2**) would be approximately:

$$R_{bc} = (\text{n-type layer resistivity} * \text{thickness of n-type layer}) / \text{area of device}$$

$$= 0.003 \text{ ohm.cm} * 0.0003 \text{ cm} / (0.03 \times 0.03 \text{ cm})$$

$$= 0.001 \text{ ohm.}$$

Therefore, the advantages of a buried contact nitride device with regard to the device efficiency based on the series resistance improvements alone is clear to appreciate. Note that it will be appreciated by the skilled addressee that the actual series resistance of a particular device is highly dependent upon the factors such as the area of the contact and the thickness and resistivty of the layers used. It also depends on the junction layers used, for instance the presence of AlGaN can add considerably to the series resistance. Therefore, the actual series resistance of any fabricated buried contact nitride semiconductor device can vary significantly (for example within the range of 0.0001 to 5 ohms), however, it will be appreciated that any improvement in the actual series resistance from existing devices has a significant advantageous effect on the wall-plug and overall efficiency of the device.

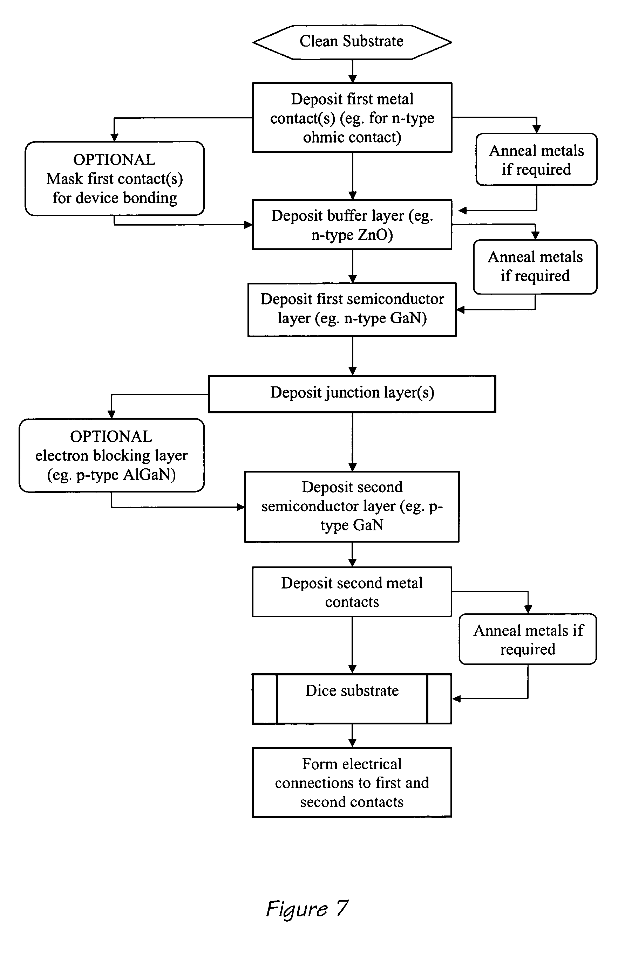

According to a further aspect, there is also provided a process for forming a semiconductor device having metal nitride layers and buried metal contacts. **Figures 7** to **9** show example process steps for forming a semiconductor device having embedded contacts of the form of **Figures 2** to **6**. In each case the substrate may be sapphire, glass, for example borosilicate or silica glass, quartz, ZnO, silicon carbide, silicon or sapphire and may be initially cleaned in the usual manner, for example using hydrogen peroxide or ammonium hydroxide rinses for glass a hydrofluoric rinse for cleaning of silicon substrates; heating a ZnO substrate to drive off hydroxide layers; or using a phosphoric acid clean for sapphire substrates; or as appreciated by the skilled addressee. The substrate may comprise a buffer layer disposed or deposited thereon.

The forming of a semiconductor device having metal nitride layers (specifically GaN layers) and buried metal contacts described herein are fabricated using a remote nitrogen plasma enhanced chemical vapour deposition (RPECVD) source by thermally decomposing trimethyl gallium in an atmosphere of nitrogen, with nitrogen excited species downstream of the plasma combining with the gallium to form GaN at temperatures in the range of about 500 to 800 degrees Celsius. Previous techniques for fabricating buried contact semiconductor devices use MOCVD techniques which typically occur at temperatures of about 1000 - 1100 degrees Celsius. The significant advantage of the present remote plasma fabrication techniques, which are described in more detail in patent applications PCT/AU2003/000598 and PCT/AU2005/001483, the contents of which are wholly enclosed herein by cross-reference, are that the embedded metal contacts do not decompose at the operating temperatures of 500 to 800 degrees (metal contacts may evaporate or form liquid pools at temperatures above 1000 degrees Celsius) and that the fabrication is performed under an atmosphere of nitrogen rather than ammonia (which may etch and degrade the embedded metal contacts during subsequent fabrication steps).With this RPECVD method, a nitrogen plasma remotely located from the reaction chamber is formed and metastable active neutral nitrogen species formed in the plasma are transported to be incident on the substrate, thereby to interact with one or more precursors to form a group-III metal nitride film on a substrate. The kinetic energy of the active species is quite low at this point (thermal energies only) whereas the potential energy of the active species can range between 6 and 12 eV. The potential energy of the metastable active neutral species is converted to other energy (kinetic, thermal, etc) when the species react to form the group-III metal nitride. The metastable active neutral nitrogen species may be metastable species of molecular nitrogen [$N_2^*$]. The transference of the active neutral nitrogen species is typically obtained via the momentum and/or kinetic energy that the nitrogen species attains from the plasma. The active neutral nitrogen species may have potential energies that are preferably in the range of between about 6 eV to about 9 eV, this being the potential energies for metastable molecular nitrogen species. The active neutral nitrogen species may react with the group three metal precursor to form a group III metal nitride semiconductor material on the substrate. The atomic nitrogen may react with the group-III metal organic precursor species to form a group-III metal organic nitride semiconductor material on the substrate.

The nitrogen from which the plasma is preferably formed from high purity nitrogen i.e. with impurity levels of less than about 10ppb (w/w, v/v or mole/mole), or less than about 9, 8, 7, 6, 5, 4, 3, 2, 1, 0.5, 0.2, 0.1, 0.05 or O.Olppb. The active neutral nitrogen species that is formed in the nitrogen plasma may have a mean energy less than or approximately equal to the bond energy of gallium nitride. There may be more than one type of active neutral nitrogen species formed. The active neutral nitrogen species, or one of the species, may be excited molecular nitrogen and may be a metastable molecular nitrogen species. A suitable activated nitrogen species is $N_2^*(A^3\Sigma_u^+)$, which has an energy of about 6 eV. Other suitable active nitrogen species include $N_2^*(B^3\Pi_g)$ and $N_2^*(a^1\Pi_g)$ which have energies of about 7.5 eV and 8.5 eV respectively. One advantage of these reactive neutral species is that they have relatively low kinetic energy and thus affect the surface of the substrate via their potential excitation energy rather than by kinetic impact therefore causing less surface damage of the film being grown.

Atomic nitrogen is also metastable and is often formed in the plasma (although usually in small amounts), and has an energy level of about 11.5eV. The atomic nitrogen species are preferably avoided as they tend to have higher potential energy and when converted to other energies (i.e. when reacting to form GaN) that excess energy can be converted to kinetic energy and can cause damage to the substrate and the semiconductor film being grown. The process of the present invention is preferable to MBE (molecular beam epitaxy) is that in the latter process it is difficult to regulate the production of higher energy species due to the use of relatively high pressures. By contrast in the present process lower pressures (commonly about 0.1 to abut 5 Torr) are used, enabling better control of high energy species and therefore less film damage.

Semiconductor group-III metal nitride devices on metal contacts may be grown on a suitable substrates (eg, sapphire, glass, quartz etc) using the REPCVD method. The metal contact may be chosen from one or more of nickel, chromium, platinum, tungsten, or molybdenum, an alloy of any one or more of the above metals, or any other suitable metal having good electrical conductivity with respect to the metal-nitride semiconductor material and a melting point greater than the growth temperature (i.e. about 600°C to 700°C). For example nichrome may be used for the metal contacts, which is an alloy of nickel and chromium having good electrical conductivity compared that of GaN (or other group-III metal nitride semiconductor materials) and an ability to withstand high temperatures, The electrical conductivity of a nichrome alloy comprising 79% nickel and 21% chromium has a resistivity of about $1.075 \times 10^{-6}$ $\Omega$.m which is many orders of magnitude more conductive than for GaN ($\sim 0.001\Omega$.cm).

In an exemplary arrangement, a double heterojunction device may be grown on a substrate comprising one or more conducting contact(s) (e.g. a metal contact formed for example from nichrome or other suitable metal or metal alloy) by the following method. The conducting contact(s) may be formed on the substrate by suitable deposition methods known in the art and may comprise the step of patterning the substrate prior to deposition of the conducting contact(s) to form appropriately configured metal contact or contacts. A conducting buffer layer may optionally be formed on the conducting contact(s) as would be appreciated by the skilled addressee.

A first metal nitride (eg. gallim nitride GaN) may be grown at a temperature in the range of about 500°C to about 700°C for a time of between about 0.5 hours to about 24 hours on the conducting contact. The reactor temperature may alternatively be in the range of 500 to 650, 500 to 600, 500 to 580, 500 to 560, 500 to 540, 520 to 700, 520 to 650, 520 to 600, 520 to 580, 530 to 560, 535 to 555, 540 to 550 or 540 to 545 and may be about 535, 538, 540, 541, 542, 543, 544, 545, 546, 547, 548, 549, 550, 553, 555, 560, 570, 58, 590, 600, 625, 650, 675 or about 700°C. The growth time for the first layer may alternatively be in the range of about 0.5 to 18, 0.5 to 12 0.5 to 10, 0.5 to 8. 0.5 to 7, 0.5 to 6, 0.5 to 5, 0.5 to 4, 0.5 to 3, 0.5 to 2.5, 0.5 to 2, 0.5 to 1, 2 to 24, 2 to 18, 2 to 12, 2 to 10, 2 to 8, 2 to 6, 2 to 5, 2 to 4, 2 to 3, 3 to 5, 3.5 to 4.5 or 3.8 to 4.2 hours, and may be about 2, 2.5, 3, 3.5, 4, 4.5, 5, 5.5 or about 6 hours depending on the desired thickness of the layer. This layer formed on the contact (to embed or bury the contact within the metal nitride semiconductor layer) may be grown in nitrogen rich conditions. Under such nitrogen rich conditions, however, care may need to be taken to minimise damage to the film by highly energetic nitrogen active species which may result in low-nitrogen film stoichometry.

The metal nitride layer may be either an n-type or p-type layer (the following discussion will assume an n-type layer although where the first layer is a p-type layer, the following description also applies mutatis mutandis). The reactor pressure for growth of this first layer may be in the range of 0.01 Torr to 5 Torr, or alternatively about 0.01 to 4, 0.01 to 3, 0.01 to 2, 0.01 to 1, 0.01 to 0.5, 0.1 to 5, 0.1 to 4, 0.1 to 3, 0.1 to 2, 0.1 to 1, 0.1 to 0.5, 1 - 5, 1 to 4, 1 to 3, 1 to 2, 1 to 1.5, 0.5 to 2, 0.5 to 1.8, 0.5 to 1.6, 0.5 to 1.5, 0.5 to 1.4, 0.5 to 1.3, 0.5 to 1.2, 0.5 to 1.1, 0.5 to 1, 0.7 to 1.8, 0.7 to 1.6, 0.7 to 1.5, 0.7 to 1.4, 0.7 to 1.3, 0.7 to 1.2, 0.7 to 1.1, 0.7 to 1, 0.8 to 1.8, 0.8 to 1.6, 0.8 to 1.5, 0.8 to 1.4, 0.8 to 1.3, 0.8 to 1.2, 0.8 to 1.1, 0.8 to 1, 0.9 to 1.8, 0.9 to 1.6, 0.9 to 1.5, 0.9 to 1.4, 0.9 to 1.3, 0.9 to 1.2, 0.9 to 1.1, 0.9 to 1, 1 to 1.8, 1 to 1.6, 1 to 1.5, 1 to 1.4, 1 to 1.3, 1 to 1.2, or 1 to 1.1 Torr, and may be approximately 0.5, 0.6, 0.7, 0.8, 0.9, 1.0, 1.1, 1.2, 1.3, 1.4, 1.5, 1.6, 1.7, 1.8, 1.9 or about 2 Torr.

The metal nitride precursor for the first layer may be delivered to the substrate by flowing nitrogen through the precursor. Example precursors may be:

trimethylgallium (TMG) for growth of GaN;

trimethylaluminium (TMA1) for growth of AlN;

trimethylindium (TMIn) for growth of InN;

or combinations of these for growth of other semiconductor materials such as AlGaN, InGaN and/or AlInGaN. Other gallium precursors may also be used as would be appreciated by the skilled addressee.

The precursor may be held at a desirable operating temperature during the growth, which is typically between the melting and boiling points of the "liquid" sources i.e. for TMG, the temperature may be in the range of about -15.8°C to 55.7°C; and for TMA1, the temperature may be in the range of about 15.4°C to 126°C. For "solid" sources such as TMIn and $Cp_2Mg$, these may be used at operating temperatures as high as their melting point i.e. for TMIn, the temperature may be up to 88°C (although more typically within the range of about 0°C to about 50°C since vapour pressure data is available within that range) and for $Cp_2Mg$ (used for Magnesium doping of the metal nitride films as a p-type dopant) up to about 176°C (or more typically within the range of about 0°C to about 50°C). Other precursors may also be used as would be appreciated by the skilled addressee, particularly for doping the metal nitride films eg. oxygen precursors among others.

Other precursor materials may also be used as required. For example p-type doping of the metal-nitride semiconductor may be achieved by incorporating magnesium in the material. The magnesium precursor may be obtained

from a Cp$_2$Mg precursor. Other precursor material(s) may alternatively be used as required.

The precursor(s) may be delivered to the substrate by a flow of gas through the precursor. For example the gas may be a nitrogen gas delivered at a desired flow rate to obtain a desired concentration of precursor at the substrate for growth of the particular film. The gas flow rate may be in the range of about 5 to 500 sccm (standard cubic centimetres per minute), or about 5 to 450, 5 to 400, 5 to 350, 5 to 300, 5 to 250, 5 to 200, 5 t 150, 5 to 100, 5 to 90, 5 to 80, 5 to 70, 5 to 60, 5 to 50, 5 to 40, 5 to 30, 5 to 20, 5 to 15, 5 to 10, 10 to 100, 10 to 90, 10 to 80, 10 to 70, 10 to 60, 10 to 50, 10 to 40, 10 to 30, 10 to 20, 10 to 15, 15 to 20, 20 to 90, 20 to 80, 20 to 70, 20 to 60, 20 to 50, 20 to 40, 20 to 30, and may be about 5, 6, 7, 8, 9, 10, 11, 12, 13, 14, 15, 16, 17, 18, 19, 20, 21, 22, 23, 24, 25, 30, 40,5 0,6 0,70 ,80 ,90 or 100 sccm in accordance with requirements i.e. the flow rates required generally scale with the deposition area, therefore the larger the deposition area, the greater the flow rate required (eg. a flow rate of about 500 sccm or greater may be required for a deposition area with diameter of about 60 cm).

The remote plasma of the RPECVD reactor may be a nitrogen plasma. Nitrogen may be flowed through the plasma tube of the RPECVD reactor at such a flow rate so as to adjust the concentration of active neutral nitrogen species present at the surface of the substrate in accordance with requirements. The flow rate of the nitrogen through the plasma tube may be in the range of approximately 300 to 1000 sccm, or about 400 to 800, 400 to 700, 400 to 600, 400 to 500, 450 to 700, 450 to 650, 450 to 600, 450 to 550, 450 to 500, 500 to 700, 500 to 650, 500 to 600, or 500 to 550 sccm, and may be about 300, 400, 450, 500, 550, 600, 650, 700, 800, 900 or 1000 sccm in accordance with requirements. Again, the flow rates required typically scale up in accordance with the deposition area, therefore flow rates of up to or greater than 30 Litres/minute (30,000 sccm) eg. for a deposition area with diameter of about 60 cm.

A second, thinner, n-type metal nitride layer may be formed on the first layer. This layer may be formed from a compound semiconductor material (eg. AlGaN, or InGaN among others). The second layer may be grown at a lower temperature than the first layer. The reactor temperature during growth of the second layer may be in the range of approximately 20°C to about 1100°C, or more typically up to temperatures of about 700°C for the current RPECVD system. The reactor temperature may alternatively be in the range of about 20 to 700, 20 to 650, 20 to 600, 20 to 550, 20 to 540, 20 to 530, 20 to 520, 20 to 510, 20 to 500, 100 to 700, 100 to 600 100 to 550, 100 to 525, 100 to 500, 250 to 700, 250 to 650, 250 to 600, 250 to 600, 250 to 550, 250 to 525, 250 to 500, 400 to 700, 400 to 650, 400 to 600, 400 to 550, 400 to 500, 500 to 700, 500 to 650, 500 to 600, 500 to 550, 500°C 540°C, 505 to 535, 510 to 530, 515 to 525 or 515 to 520°C and may be about 500, 505, 508, 509,, 510, 512, 513, 514, 515, 516, 517, 518, 519, 520 521, 522, 523, 524, 525, 528, 530, 535 or 540°C. The second layer may be grown over a period of between about 30 seconds to about 3 hours or alternatively 1 minute to 3 hours, 1 minute to 2 hours, 1 minute to 1 hour, 1 to 30 minutes, 5 minutes to 3 hours, 5 minutes to 2 hours, 5 minutes to 1 hour, 5 to 30 minutes, 5 to 25, 5 to 20, 5 to 15, 10 to 30, 10 to 25, 10 to 20, 10 to 15 minutes and may be about 0.5, 1, 2, 3, 4, 5, 6, 7, 8, 9, 10, 11, 12, 13, 14, 15, 16, 17, 18, 19, 20, 25, 30, 40, 50, 60 minutes or about 1.5, 2, 2.5 o 3 hours as required.

The reactor pressure during growth of the second layer may be higher than that as for the first layer and may be in the range of approximately 0.01 Torr to 5 Torr, or alternatively 0.01 to 4, 0.01 to 3, 0.01 to 2, 0.01 to 1, 0.01 to 0.5, 0.1 to 5, 0.1 to 4, 0.1 to 3, 0.1 to 2, 0.1 to 1, 0.1 to 0.5, 1 - 5, 1 to 4, 1 to 3, 1 to 2, 1 to 1.5, 0.5 to 2, 2 to 5, 2 to 4.5, 2 to 4, 2 to 3.5, 2 to 3, 2.5 to 4, 2.5 to 3.5, 2.5 to 3, 2.8, - 3.5, 2.8 to 3.2 Torr and may be about 2, 2.5, 2.7, 2.8, 2.9, 3.0, 3.1, 3.2, 3.3, 3.4, 3.5, 3.7, 3.8, 4.0, 4.5 or about 5 Torr.

The reactor temperature may be decreased (or increased between the growth of the first and the second layers (or between any subsequent layers as required). In this temperature reduction phase, a flow of nitrogen may be maintained through the plasma tube of the remote nitrogen plasma source, but with no plasma present. The nitrogen flow through the plasma tube during this phase may be in the range of about 400 to 650 sccm or alternatively 450 to 600 or 500 to 550 sccm, and may be about 450, 500, 550, 600 or 650 sccm. The reactor pressure may be increased (or alternatively decreased) during this phase as required for growth of the next layer in the device. Again, the flow rates required typically scale up in accordance with the deposition area, therefore flow rates of up to or greater than 30 Litres/minute (30,000 sccm) eg. for a deposition area with diameter of about 60 cm.

A first p-type layer may next be deposited on the n-type layer layer at a temperature in the range of approximately 500°C to about 700°C for a time of between about 0.5 minutes to about 3 hours . The third layer may be a further compound semiconductor material, and may comprise a p-type dopant. The reactor temperature may alternatively be in the range of 500 to 650, 500 to 600, 500 to 580, 500 to 560, 500 to 540, 500 to 250, 500 to 510, 505 to 535, 510 to 530, 515 to 525 or 515 to 520°C and may be about 500, 505, 508, 509,, 510, 512, 513, 514, 515, 516, 517, 518, 519, 520 521, 522, 523, 524, 525, 528, 530, 535 or 540°C. The temperature may be approximately the same temperature as for the second layer. The pressure may be approximately the same as the pressure for the second layer. The third layer may be grown over a shorter period than for the second layer and may be in the range of approximately 2 to 15 minutes, or alternatively 3 to 15, 3 to 10, 3 to 6, 3 to 5, 4 to 10, 4 to 6 minutes and may be about 2, 3, 4, 5, 6, 7, 8, 9, 10, 12 or about 15 minutes.

One, two, three, four, five, or more layers may optionally be formed on the first p-type layer under similar conditions as would be appreciated by the skilled addressee to form alternative junction types for example, single quantum well device, or multi-quantum well devices in the junction region. The junction region may comprise a simple p-n, n-p, p-n-p or n-p-n junction, or, in other arrangements the junction region may be a single quantum well junction or a multi-quantum well junction. The junction region may comprise a multi-quantum well junction with 2, 3, 4, 5, 6, 7, 8, 9, 10 or more quantum wells contained therein. There may be more than one junction region, for example there may be two, three, four, five six, seven, eight, nine, or ten or more junction regions.

A second p-type layer may be grown in the first p-type layer. The reactor temperature may be in the range of approximately 500°C to about 700°C, 500 to 650, 500 to 600, 500 to 580, 500 to 560, 500 to 540, 505 to 535, 510 to 530, 515 to 525 or 515 to 520°C and may be about 500, 505, 508, 509" 510, 512, 513, 514, 515, 516, 517, 518, 519, 520 521, 522, 523, 524, 525, 528, 530, 535 or 540°C. The reactor pressure may be in the range of approximately 0.01 Torr to 5, or alternatively about 0.01 to 4, 0.01 to 3, 0.01 to 2, 0.01 to 1, 0.01 to 0.5, 0.1 to 5, 0.1 to 4, 0.1 to 3, 0.1 to 2, 0.1 to 1, 0.1 to 0.5, 1 - 5, 1 to 4, 1 to 3, 1 to 2, 1 to 1.5, 2 to 5, 2 to 4.5, 2 to 4, 2 to 3.5, 2 to 3, 2.5 to 4, 2.5 to 3.5, 2.5 to 3, 2.8, - 3.5, 2.8 to 3.2 Torr and may be about 2, 2.5, 2.7, 2.8, 2.9, 3.0, 3.1, 3.2, 3.3, 3.4, 3.5, 3.7, 3.8, 4.0, 4.5 or about 5 Torr. The second p-type layer may be grown over a period of between about 30 seconds to about 3 hours, or alternatively 1 minute to 3 hours, 1 minute to 2 hours, 1 minute to 1 hour, 1 to 30 minutes, 5 minutes to 3 hours, 5 minutes to 2 hours, 5 minutes to 1 hour, 5 to 30 minutes or alternatively 5 to 25, 5 to 20, 5 to 15, 10 to 30, 10 to 25, 10 to 20, 10 to 15 minutes and may be about 0.5, 1, 2, 3, 4, 5, 6, 7, 8, 9, 10, 11, 12, 13, 14, 15, 16, 17, 18, 19, 20, 25, 30, 40, 50, 60 minutes or about 1.5, 2, 2.5 o 3 hours as required. The second p-type layer may be grown over approximately the same time as the second n-type layer and may be approximately the same thickness as the second n-type layer.

The final layer grown may be a thick p-type metal nitride layer grown over a period of approximately 15 minutes to 6 hours, 15 minutes to 5 hours, 15 minutes to 4 hours, 15 minutes to 3 hours, 15 minutes to 2 hours, 15 minutes to 1 hour, 0.5 to 6 hours, 0.5 to 5, 0.5 to 4, 0.5 to 3 0.5 to 2, 0.5 to 1, 1 to 6, 1 to 5, 1 to 4, 1 to 3, 1 to 2, 2 to 6 hours, 3 to 5, 3.5 to 4.5 or 3.8 to 4.2 hours, and may be grown over about 0.25 (15 minutes), 0.5 (30 minutes), 0.75 (45 minutes), 1, 1.5, 2, 2.5, 3, 3.5, 4, 4.5, 5, 5.5 or about 6 hours. The reactor temperature may be higher than the reactor temperature for the second p-type layer and may be in the range of approximately500°C to about 700°C, or alternatively 500 to 650, 500 to 600, 500 to 580, 500 to 560, 500 to 540, 520 to 700, 520 to 650, 520 to 600, 520 to 580, 520°C to 560°C, 525 to 555, 530 to 550 or 530 to 545, 530 - 540, 530 - 535 and may be about 520, 525, 530, 531, 532, 533, 534, 535, 536, 537, 538, 539, 540, 542, 544, 546, 548, 550, 553, 555, 560, 570, 58, 600, 625, 650, 675 or about 700°C.

Other device structures (e.g. a single or multi-quantum well junction or some other type of semiconductor junction device) may be grown as would be appreciated by the skilled addressee by modification of the number of layers, the type (n- or p-type) of each layer, the growth time for each layer, the precursor(s) and/or dopant(s) for each layer etc.

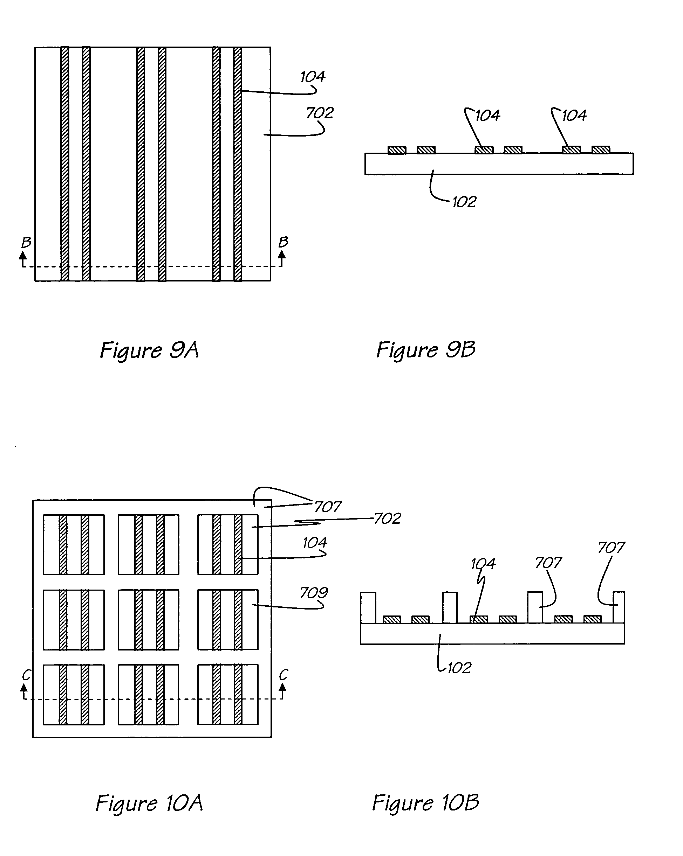

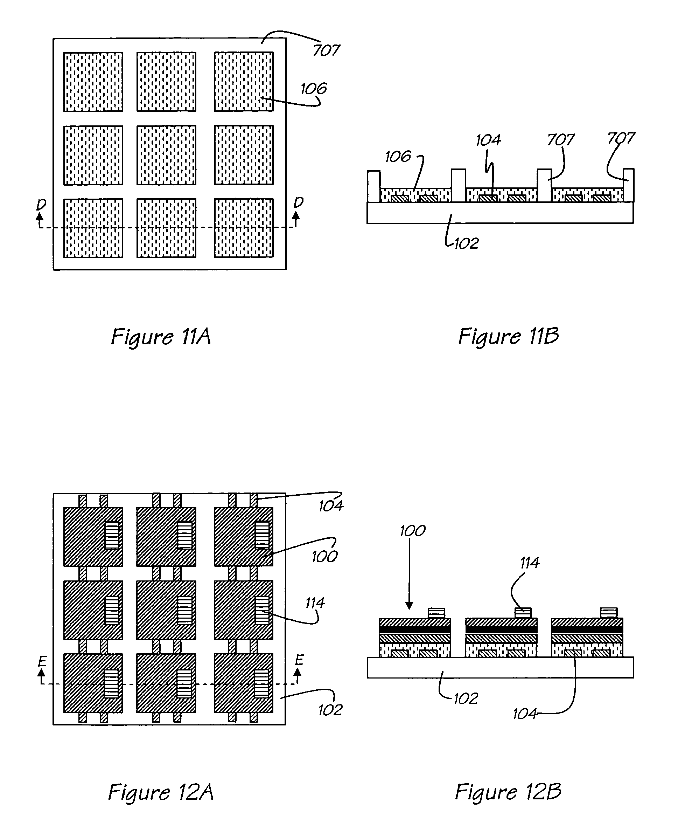

**Figure 7** depicts the process for a semiconductor device where the first metal contacts are to be embedded into the buffer layer as depicted in **Figure 3**. The first metal contacts **104** (for example n-type GaN ohmic metals contacts) are deposited onto the substrate **702** (as depicted in **Figure 9A** and **9B**) and annealed **704** if required. Optionally, a masking layer (707 of **Figures 10A** to **11B**), for example a mechanical "shadow-type" mask, is then applied **706** to mask the first metal contacts during further processing. The mask is used to define a plurality of regions (**709** of **Figure 10A)** on the substrate where a corresponding plurality of semiconductor devices are to be formed, such that, when the required layers of the structure have been deposited on the substrate, the mask may be removed to expose the first metal contacts (as depicted in **Figure 2**) to allow electrical connections to be readily made thereto. A buffer layer **106** (for example ZnO -either insulating or n-type) is then deposited **708** over the first metal contacts (as depicted in **Figures 11A** and **11B**). Again, annealing of the metals is performed if required. Generally, the annealing step (which must be performed under an atmosphere of nitrogen for GaN devices) is required where the contacts are not to be covered by a layer of the device, for example where a portion of the embedded contacts is to remain uncovered for electrical contacting (as depicted in **Figure 2**) or for the top p-layer contact (eg. second contact **114** of **Figure 2 -** however, not all such electrical or ohmic contacts are required to be annealed) as the temperature at which subsequent layers of the device are laid is similar to that of the usual metal annealing temperatures, and the subsequent layer growth also acts to anneal the contacts. Also, the anealling process when performed may be a rapid thermal anealling process where the device is rapidly raised to the annealing temperature (typically 400 - 800 degrees Celsius over a period of 1 to 10 seconds (typically about 2 to 5 seconds) and maintained at the anealling temperature for a time period of about 2 to 20 minutes (typically about 5 to 10 minutes) before being rapidly cooled, at least initially, over a period of tens of seconds, although this may vary dependent upon, primarily, the annealing equipment available as will be appreciated by the skilled addressee..

The first semiconductor layer **108** is then deposited **710** over the buffer layer followed by deposition 712 of the active layer(s) of the device (for example an InGaN layer, InGaN/GaN multi-quantum well, or single quantum well layers). The second semiconductor layer **112** is then deposited **714** over the junction and the second metal contact (for example, p-type GaN ohmic metals contacts) deposited **716** on the second semiconductor layer and the metals annealed **718** if required. Optionally, an electron blocking layer, for example an AlGaN p-type layer, may be deposited **718** intermediate steps **712** and **714** so as to stop electrons from passing through the junction region of the device and recombining outside the junction region, thereby causing a double emission effect to be observed. The electron blocking layer is generally a material having a higher bandgap than the adjacent junction region and a doped (i.e. n- or p-type) semiconductor layer, for example, an electron blocking layer between a junction region and a p-type semiconductor layer would comprise an additional p-type layer (eg. p-AlGaN) intermediate the junction region and the p-type semiconductor layer.

The mask (if used) is then removed to again expose the first contacts (**104** of **Figures 12A** and **12B**) which are now buried (or embedded) within the plurality of mesa-like semiconductor devices **100** formed on the substrate **102,** and the substrate diced **720** to for a plurality of independent semiconductor devices **100** as depicted in **Figure 2**. Finally, the first and second metal contacts are electrically connected **722** in the normal manner for operation of the semiconductor device.

Where the optional step of masking the first metal contacts is not performed, the resulting semiconductor devices after the dicing step do not have the first metal contacts readily exposed for electrical connections to be made thereto. Thus, additional process steps must be performed to enable electrical or ohmic contacts to the wholly embedded first contacts. Such additional processes may comprise etching through the fabricated semiconductor device to expose the first contact, or lifting the entire fabricated device from the substrate and directly contacting to the first contacts from the exposed underside of the device. Techniques for lifting the fabricated device from the substrate may include laser induced lifting techniques, or may include techniques specific to the type of substrate used. For example, in the case of a sapphire substrate, a ZnO layer may be initially formed on the substrate prior to fabrication of the semiconductor device, and on completion of the device fabrication, the initial ZnO layer may be etched away, thereby releasing the fabricated device from the sapphire substrate and exposing the first metal contacts for subsequent contacting.

The advantage of not masking the contacts and forming a semiconductor device with wholly embedded contact in this manner are that, as will be appreciated by the skilled addressee, masks can be difficult to work with in a film growth system and, without suitable care, can cause a number of problems such as shadowing of exposed region, and diffusion of a subsequently grown layer occurring underneath the mask and causing the edges of the mask region to be unclear. Thus, it may be advantageous to remove masking steps where possible.

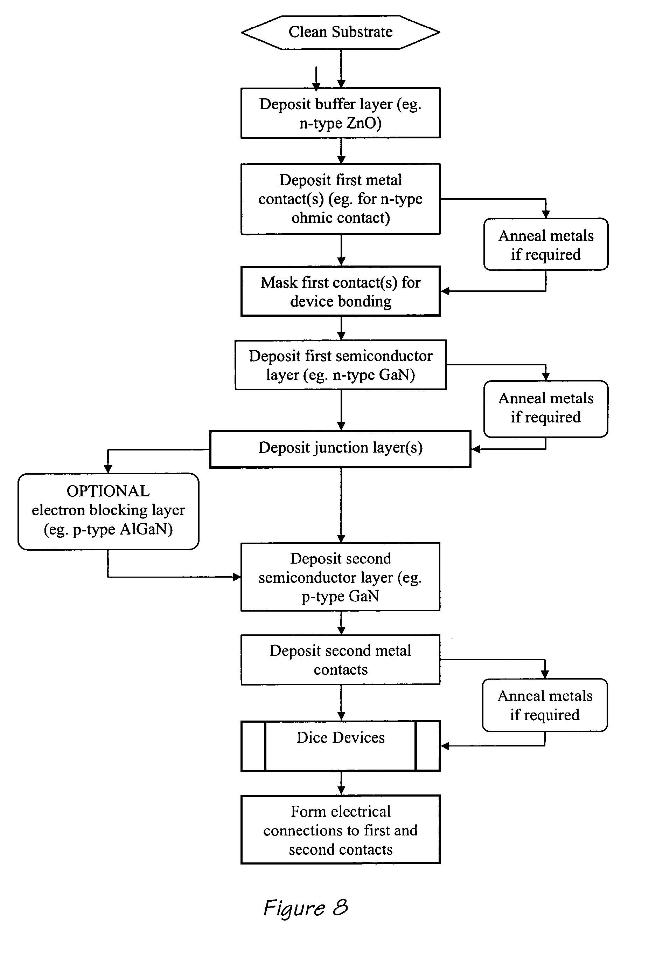

**Figure 8** depicts a process similar to that of **Figure 7** for forming a semiconductor device with the first metal contacts formed within the doped semiconductor layer as depicted in **Figure 6**, where like steps with respect to the process of **Figure 7** are depicted with like reference numerals. The buffer layer deposited in step **724** may alternately be a buffer layer as per step **708** of **Figure 7** (eg a ZnO layer - either insulating or doped n- or p-type), or may be a metal nitride layer as depicted in **Figure 6.** Alternately still, the buffer layer deposition step **724** may be omitted completely such that the first metal contacts are deposited directly on to the substrate and the first doped semiconductor layer (i.e. a metal nitride layer as previously described) deposited onto the substrate over the first contacts, thereby embedding the first contacts in the first semiconductor layer.

**Example**

Gallium nitride devices on metal have been grown on sapphire substrates using the RPECVD method described above. In one example, a double heterostructure junction device comprising 5 layers has been demonstrated. The device was grown on a sapphire substrate which had a contact layer of nichrome deposited on the surface of the substrate prior to being placed in the RPECVD growth chamber. Nichrome is an alloy of nickel and chromium with high electrical resistance and an ability to withstand high temperatures.

An n-type GaN layer was grown at 541°C for four hours on the nichrome layer at a reactor pressure of about 1.3 Torr. The precursor for the n-type GaN layer was delivered to the sample by flowing nitrogen through trimethylgallium (TMG) being held at -10°C at a rate of 20 sccm (standard cubic centimetres per minute). Nitrogen was flowed through the plasma tube of the RPECVD reactor (with a plasma present at a rate of 600 sccm to form active neutral species of nitrogen which react with the TMG to form gallium nitride on the nichrome layer. The precusor mix of TMG and active neutral nitrogen species was also diluted by a flow of nitrogen through the TMG delivery line at a rate of 100 sccm.

The temperature of the reactor chamber was next reduced over a period of about 7 minutes at a temperature of about 524°C and the chamber pressure increased to about 3 Torr. During this phase, a nitrogen flow of 500 sccm was maintained through the plasma tube but with no plasma present. The advantage of maintaining the nitrogen flow even when there is no plasma is to minimise nitrogen evaporation from the film which may occur under certain vacuum conditions. The temperature in the reactor chamber is reduced to allow the growth of InGaN. The InGaN layer generally needs a lower growth temperature than the GaN as the indium component dissociates very readily and may not otherwise incorporate in the film.

An n-type AlGaN layer was then deposited over 10 minutes on the n-type GaN layer at a temperature of 517°C and pressure of 3 Torr. TMG and trimethylaluminium (TMA1) precursors were used with a flow rate of 16 sccm and 15 sccm respectively. The TMG is again held at a temperature of -10°C and the TMA1 is held at a temperature of 25°C. The nitrogen flow rate through the plasma tube (with plasma) was 500 sccm.

The third layer was a p-type InGaN layer grown at a temperature of 518°C and pressure of 3 Torr over 5 minutes. The precursors used were TMG and trimethylindium (TMIn), each at a rate of 10 sccm. The p-type dopant was magnesium (Mg) from a $Cp_2Mg$ precursor held at 23°C with a flow rate of 10 sccm. The nitrogen flow rate through the plasma tube (with plasma) was 600 sccm.

The next layer was a p-type AlGaN layer grown at a temperature of 520°C and pressure of 3 Torr over 15 minutes. The precursors used were TMG and TMA1 with $Cp_2Mg$ used for the Mg p-type dopant, at rates of 16 sccm, 15 sccm and 40 sccm respectively. The nitrogen flow rate through the plasma tube (with plasma) was 500 sccm.

The final layer (for this example) was a p-type GaN layer grown at a temperature of 534°C and pressure of 3 Torr over 2 hours. The precursors used were TMG with $Cp_2Mg$ used for the Mg p-type dopant, at rates of 16 sccm and 50 sccm respectively. The nitrogen flow rate through the plasma tube (with plasma) was 500 sccm.

The total thickness of the final device was approximately 800 nm thick indicating a growth rate of approximately 125 nm per hour for the RPECVD system.

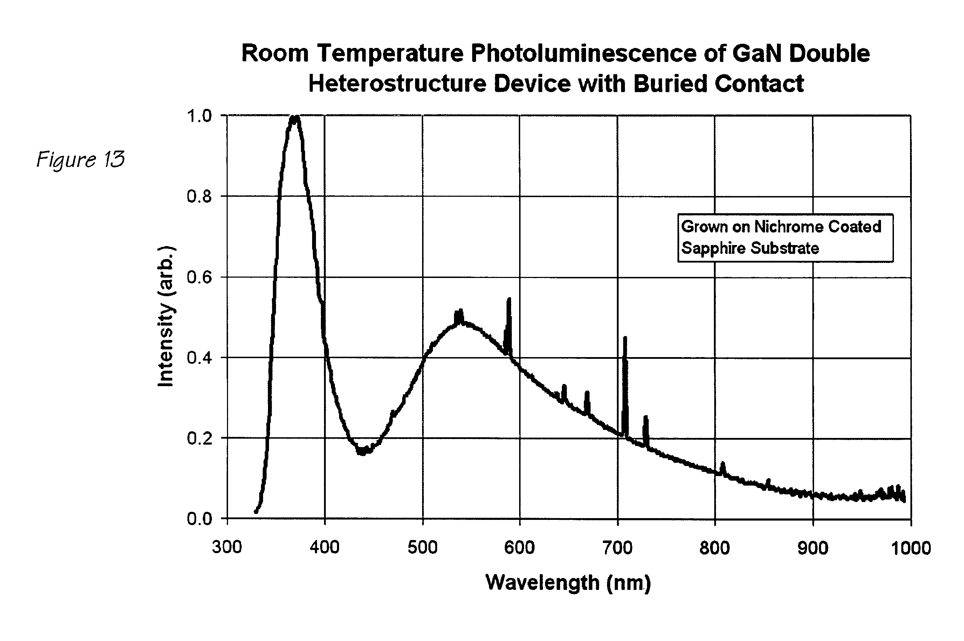

**Figure 13** shows a graph of the room temperature photoluminescence from the double heterostructure junction GaN structure grown as per the above example formed on a nichrome layer. The graph clearly displays strong luminescence in both the visible and in the ultraviolet centred at about 372 nm. The visible emission is due to a contamination in the film imparted during the growth process which may be any one or more of carbon, hydrogen, oxygen or water, although there is still much debate in the literature about the exact nature of this contamination. By growing the device in an environment that minimises these possible contaminations, the defect contamination can be advantageously minimised.

Electrical connections were also made between the embedded nichrome layer and the top layer of the device and the device was found to be electrically conductive and emitted light from the junction.

It will be appreciated that the semiconductor devices and processes for their manufacture described and/or illustrated above at least substantially provide a metal nitride semiconductor device having embedded/buried contacts.

The semiconductor devices and processes for their manufacture described herein, and/or shown in the drawings, are presented by way of example only and are not limiting as to the scope of the invention. Unless otherwise specifically stated, individual aspects and components of the semiconductor devices and processes for their manufacture may be modified, or may have been substituted therefore known equivalents, or as yet unknown substitutes such as may be developed in the future or such as may be found to be acceptable substitutes in the future. The semiconductor devices and processes for their manufacture may also be modified for a variety of applications while remaining within the scope and spirit of the claimed invention, since the range of potential applications is great, and since it is intended that the present semiconductor devices and processes for their manufacture be adaptable to many such variations.

**Claims**

1. A semiconductor device comprising:

   a substrate;
   a first contact;
   a first layer of doped semiconductor material deposited on the substrate;
   a semiconductor junction region deposited on the first layer;
   a second layer of doped semiconductor material deposited on the junction region, the second layer having opposite semiconductor doping polarity to that of the first layer; and
   a second contact;

   wherein the second contact is in electrical communication with the second layer and the first contact is embedded within the semiconductor device between the substrate and the junction region and is in electrical communication with the first layer.

2. A device according to claim 1 wherein the first and second layers of semiconductor material are semiconductor nitride layers.

3. A device according to claim 2 wherein the semiconductor nitride layers are selected from GaN, AlGaN and InGaN semiconductor nitrides.

4. A device according to claim 1 wherein the first contact is embedded within the first semiconductor layer.

5. A device according to claim 1 further comprising a buffer layer intermediate the substrate and the first semiconductor layer, wherein the first contact is embedded within the buffer layer.

6. A device according to claim 5 wherein the buffer layer is selected from the group of an insulating buffer layer or an active semiconductor buffer layer.

7. An embedded contact semiconductor device formed from semiconductor nitride materials comprising:

    a substrate
    at least one first contact on the substrate;
    a first semiconductor nitride layer wherein the first contact is embedded in the first layer and in electrical communication with the first layer;
    a junction region adjacent the first semiconductor layer;
    a second semiconductor nitride layer adjacent the junction region;
    a second contact adjacent to the second semiconductor layer and in electrical communication with the second layer;

    wherein the first and second contacts are electrically interconnected through the junction region.

8. An embedded contact metal nitride semiconductor device comprising:

    a substrate;
    a first metal nitride layer deposited on the substrate;
    at least a first contact formed on the first metal nitride film;
    a second metal nitride layer deposited on the first metal nitride layer encapsulating at least a portion of the first contact;
    a semiconductor junction region deposited on the second metal nitride layer;
    a third metal nitride layer deposited on the junction region, the third metal nitride layer having opposite semiconductor doping polarity to that of the first and second metal nitride layers; and
    a second contact in electrical communication with the third metal nitride layer.

9. The device of any one of claims 1 to 8 wherein the substrate is borosilicate glass, silica glass, sapphire, quartz, ZnO, silicon carbide or silicon.

10. The device of any one of claims 1 to 8 wherein the device is a GaN blue LED, GaN based blue LED, GaN blue laser diode or GaN based blue laser diode.

11. A process of forming an embedded contact semiconductor nitride device comprising the steps of:

    providing a substrate comprising at least one first contact;
    masking a first portion of the first contact to expose at least one device region comprising a second portion of the first contact;
    forming a first semiconductor nitride layer over the second portion of the first contact in the device region thereby to embed the first contact within the first layer;
    forming a junction over the first layer;
    forming a second semiconductor nitride layer over the junction;
    forming a second contact on the second layer; and
    removing the mask thereby exposing the first portion of the first contacts.

12. A process of forming an embedded contact semiconductor nitride device comprising the steps of:

    providing a substrate comprising at least one first contact;
    forming a first semiconductor nitride layer over the first contact thereby to embed the first contact within the first layer;
    forming a junction over the first layer;
    forming a second semiconductor nitride layer over the junction; and
    forming a second contact on the second layer.

13. A process according to either claim 11 or claim 12 wherein the first and second semiconductor nitride layers are selected from GaN, AlGaN and InGaN semiconductor nitrides.

14. A process according to any one of claims 11 to 13 wherein the first and second semiconductor nitride layers are formed at a temperature in the range of approximately 500 to 800 degrees Celsius.

**15.** A process according to any one of claims 11 to 14 wherein the semiconductor layers are formed by a remote plasma fabrication technique under nitrogen atmosphere.

PRIOR ART
FIGURE 1

100

114    104    104

A

112

120

118

116

108

106

102

104    104

FIGURE 2

FIGURE 3

FIGURE 4

FIGURE 5

400

414

412

410

420

418

416

408

404

402

406    406

FIGURE 6

Figure 7

Figure 8

Figure 9A

Figure 9B

Figure 10A

Figure 10B

Figure 11A

Figure 11B

Figure 12A

Figure 12B

**Room Temperature Photoluminescence of GaN Double Heterostructure Device with Buried Contact**

*Figure 13*

Grown on Nichrome Coated Sapphire Substrate

Intensity (arb.)

Wavelength (nm)

EP 2 017 884 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006034540 A
- AU 2003000598 W
- AU 2005001483 W

**Non-patent literature cited in the description**

- **HA et al.** *IEEE Photonic Technology Letters,* 2008, vol. 20 (3), 175-177
- **CHAKRABORTY et al.** *IEEE Transactions of Electron. Devices,* 2007, vol. 54 (5